Europäisches Patentamt

(19) European Patent Office

Office européen des brevets

(11) Numéro de publication: **0 062 604**
**B1**

# (12) FASCICULE DE BREVET EUROPEEN

(45) Date de publication du fascicule du brevet:
30.05.84

(51) Int. Cl.³: **H 03 H 9/10**, H 05 K 5/06

(21) Numéro de dépôt: **82810102.2**

(22) Date de dépôt: **08.03.82**

(54) **Oscillateur piézo-électrique et procédé pour sa fabrication.**

(30) Priorité: **02.04.81 CH 2237/81**

(43) Date de publication de la demande:
**13.10.82 Bulletin 82/41**

(45) Mention de la délivrance du brevet:
**30.05.84 Bulletin 84/22**

(84) Etats contractants désignés:
**DE FR GB**

(56) Documents cités:
**neant**

(73) Titulaire: **EBAUCHES S.A., Faubourg de l'Hôpital 1, CH-2001 Neuchâtel (CH)**

(72) Inventeur: **Laesser, Claude, Rue du Nord 149, CH-2300 La Chaux-de-Fonds (CH)**

(74) Mandataire: **Gresset, Jean et al, ASUAG Département Brevets et Licences Faubourg du Lac 6, CH-2501 Bienne (CH)**

## Description

La présente invention concerne les oscillateurs piézo-électriques notamment applicables en horlogerie. L'invention concerne, plus particulièrement, les oscillateurs comprenant un élément piézo-électrique tel qu'un cristal de quartz monté à l'intérieur d'un boîtier étanche contenant soit du vide, soit un gaz inerte.

Un tel boîtier est généralement constitué par deux pièces scellées l'une à l'autre par un joint de scellement en matériau durcissable destiné à assurer à la fois la fixation mécanique desdites pièces l'une à l'autre et l'étanchéité de la fermeture du boîtier. Ce joint de scellement doit être réalisé dans une enceinte dans laquelle on a fait le vide. Cette exigence limite le choix des matériaux utilisables pour constituer ce joint de scellement, aux matériaux métalliques de soudure ne dégazant pas et ayant une bonne tenue sous vide. Ces matériaux étant conducteurs de l'électricité, il est donc nécessaire d'isoler électriquement vis-à-vis du joint de scellement, les métallisations prévues sur l'une des pièces du boîtier pour assurer la connexion électrique du cristal de quartz. Ainsi, selon l'art antérieur décrit dans le brevet des Etats-Unis d'Amérique no 4 191 905, cet isolement est obtenu en déposant, sur ces métallisations, une substance isolante, avant de procéder au scellement du boîtier au moyen d'un matériau métallique de soudure. Ceci constitue une opération supplémentaire rendant la fabrication de cet oscillateur compliquée et augmentant son prix de revient. Par ailleurs, l'utilisation d'un matériau métallique de soudure nécessite le chauffage du boîtier aux températures relativement élevées de fusion de ce matériau risquant de détériorer le cristal de quartz.

Selon l'art antérieur connu par le brevet britannique no 1 568 985, les métallisations servant à la connexion électrique du résonateur en cristal de quartz sont prévues, non pas sur l'une des pièces du boîtier, mais sur l'une des faces d'un cadre en quartz entourant le résonateur en cristal de quartz et venu d'une seule pièce avec ce dernier. L'ensemble formé par ledit cadre et le cristal résonateur est d'abord fixé sur l'une des pièces de boîtier au moyen d'un joint en verre à bas point de fusion, cette opération étant réalisée à la pression atmosphérique. Puis le boîtier est scellé sous vide par la fixation de l'autre pièce de boîtier sur le cadre en quartz au moyen d'un joint en un matériau de soudure métallique. Cet oscillateur connu est donc, lui aussi, de fabrication compliquée et coûteuse et présente lui aussi l'inconvénient inhérent à l'utilisation d'un matériau de soudure métallique.

C'est pourquoi l'un des buts de la présente invention est de proposer un oscillateur piézo-électrique dont le scellement puisse être réalisé au moyen d'un matériau de scellement électriquement isolant et ayant la propriété de durcir à des températures relativement basses.

Selon l'invention, les pièces constituant le boîtier de l'oscillateur piézo-électrique présentent, dans une zone périphérique, une première surface annulaire par laquelle lesdites pièces prennent mutuellement appui. Les moyens de scellement de ce boîtier comprennent a) un joint d'étanchéité joignant l'une à l'autre de façon étanche lesdites surfaces d'appui desdites pièces du boîtier, et b) un joint de fixation pour solidariser l'une avec l'autre lesdites pièces du boîtier par une seconde surface de ces dernières.

Ainsi, ce joint d'étanchéité permet de réaliser un assemblage provisoire des pièces du boîtier en réalisant le vide à l'intérieur de ce dernier et de mettre en place ensuite le joint de fixation, à la pression atmosphérique. Le choix du matériau durcissable constitutif de ce joint de fixation n'est donc plus limité aux matériaux ayant une bonne tenue sous vide. Il est donc possible de choisir un matériau électriquement isolant.

Selon un mode de réalisation actuellement préféré, le joint d'étanchéité est réalisé en une cire minérale, c'est-à-dire en une substance à base d'hydrocarbure ayant une température de fusion supérieure à la température ambiante, telle que les substances connues sous le nom commercial de Apiezon; le joint de fixation est, lui, constitué en une matière organique polymérisable telle qu'une résine époxy.

Les caractéristiques et avantages de l'invention seront mieux compris à la lecture de la description qui va suivre d'un exemple de réalisation, description faite en référence aux dessins annexés dans lesquels:

– la fig. 1 est une coupe verticale suivant le plan I–I de la fig. 2, d'un oscillateur piézo-électrique, selon un mode de réalisation de l'invention;

– fig. 2 est une vue en plan à partir du plan II–II de la fig. 1;

– la fig. 3 est une coupe transversale verticale suivant le plan III–III de la fig. 2;

– la fig. 4 est une vue analogue à la fig. 2 montrant une pluralité de pièces de boîtier réalisées dans une même plaque;

– les fig. 5a à 5e représentent schématiquement différentes étapes d'un procédé de réalisation de la plaque de la fig. 4, selon un mode de réalisation de l'invention; et

– les fig. 6a à 6c représentent différentes étapes d'un procédé de scellement de boîtiers d'oscillateur selon un mode de réalisation de l'invention.

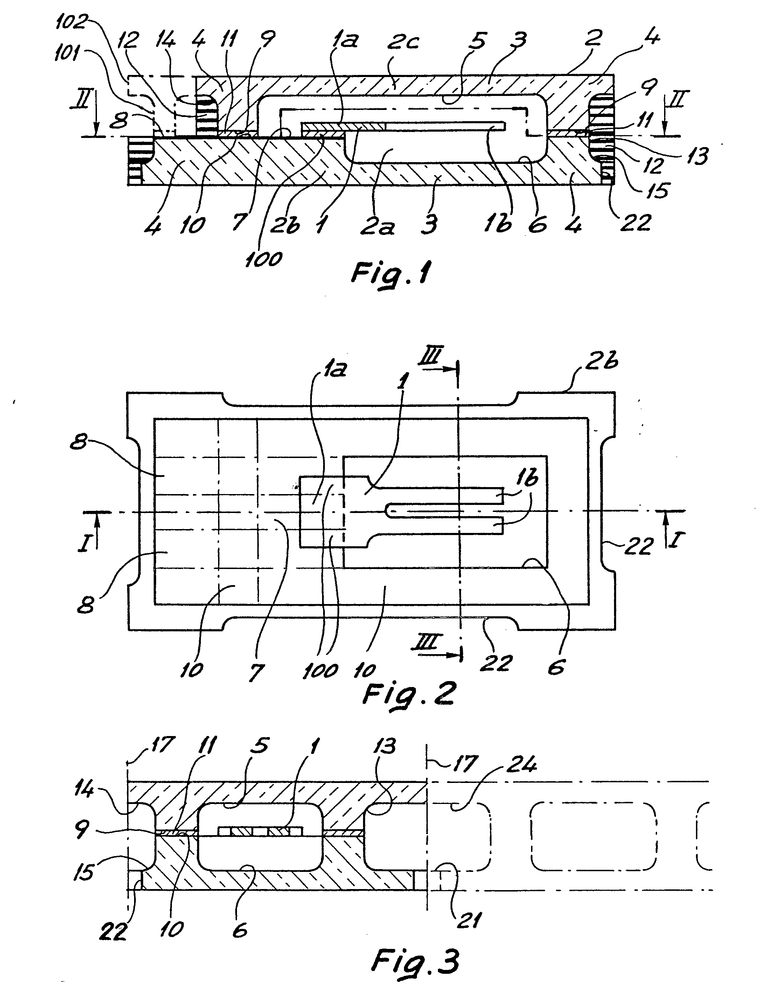

L'oscillateur représenté sur les fig. 1 à 3 comprend un élément piézo-électrique en quartz taillé en diapason 1, qui est monté dans la cavité 2a d'un boîtier hermétique 2 en verre. Le boîtier 2 est formé par le scellement d'une pièce inférieure 2b et d'une pièce supérieure 2c.

Chaque pièce 2b, 2c du boîtier 2 comprend une partie centrale 3 délimitant la cavité 2a, et une partie périphérique 4 entourant ladite partie centrale 3.

La pièce supérieure 2c présente dans sa partie centrale 3 une creusure 5 de forme compacte constituant, avec une creusure analogue 6 de la pièce inférieure 2b, la cavité 2a du boîtier 2.

Le quartz 1 est collé par sa base 1a sur une face 7 de la pièce inférieure 2b, de telle sorte que ses branches 1b s'étendent au-dessus de la creusure 6. La face 7 de la pièce 2b comporte des métallisations 8 destinées au raccordement électrique du quartz 1. Le collage du quartz 1 sur la face 7 est réalisé de façon connue au moyen de deux points 100 de colle époxy électro-conductrice ou de soudure à l'étain.

La pièce supérieure 2c présente dans sa partie périphérique 4 une surface plane annulaire en saillie 9 de forme rectangulaire par laquelle ladite pièce 2c prend appui sur une surface annulaire plane correspondante 10 de la pièce inférieure 2b.

Une couche d'une matière d'étanchéité 11 est interposée entre les surfaces 9 et 10. Cette matière d'étanchéité est une cire ayant une température de fusion supérieure à la température ambiante, telle que les cires minérales à base d'hydrocarbure de poids moléculaire supérieur à 140. Dans le présent exemple, on utilise comme matière d'étanchéité le produit de dénomination Apiezon 140 commercialisé par la société Applied Science, Etats-Unis. On pourrait également utiliser comme matière d'étanchéité une cire végétale. L'épaisseur de la couche 11 est, de préférence, comprise entre 5 et 50 μm.

La fixation mutuelle des pièces 2b et 2c est assurée par un joint réalisé en un matériau durcissant à basse température 12, ce matériau remplissant une rainure périphérique 13 du boîtier 2. La rainure 13 est délimitée, d'une part, par la paroi 14 d'un évidement ménagé dans la pièce supérieure 2c à la périphérie de la surface d'appui 9, et, d'autre part, par la paroi 15 d'un évidement analogue ménagé dans la pièce inférieure 2b à la périphérie de la surface d'appui 10 mais seulement sur trois côtés de cette surface d'appui 10.

Selon l'exemple représenté sur les dessins, lesdits évidements forment un amincissement périphérique des pièces 2b et 2c. Sur le côté adjacent à la base 1a du quartz 1, de la face d'appui 9, la rainure 13 est délimitée du côté de la pièce inférieure 2b par la face 7 elle-même.

Le matériau constitutif du joint de fixation 12 est avantageusement une résine époxy, et, plus particulièrement, la résine époxy à deux composants commercialisée par la société Epoxy Technology Inc, Wattertown, Massachusetts, sous le nom commercial de Epotek 72.

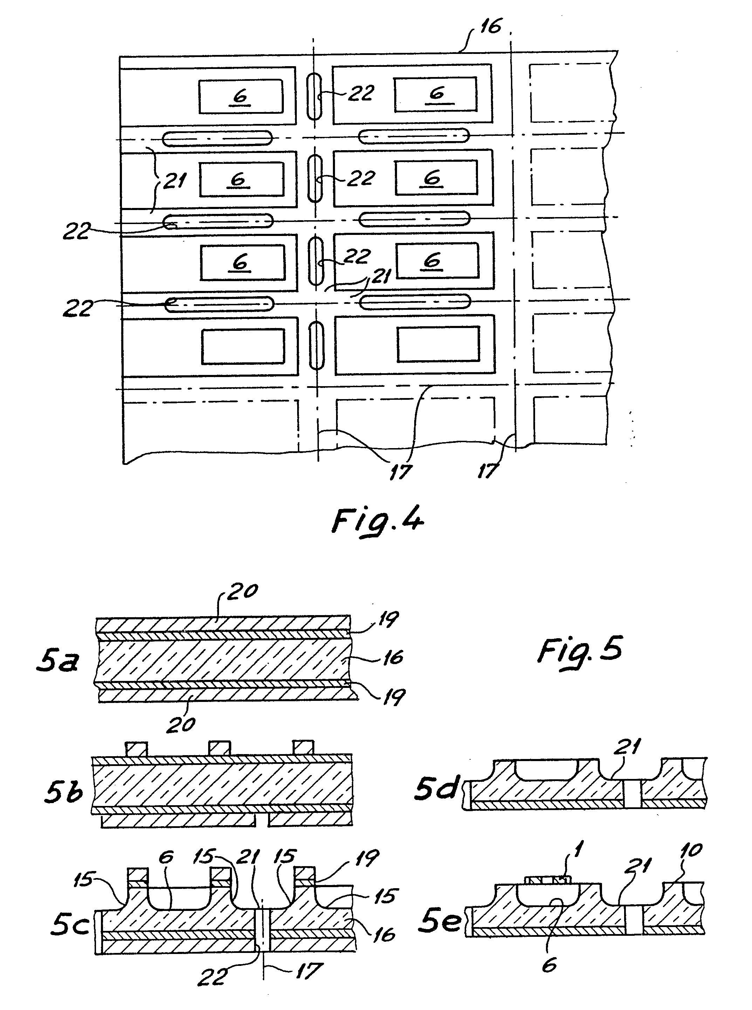

Comme on peut le voir sur la fig. 4, plusieurs pièces inférieures 2b de boîtier 2 sont fabriquées en série par gravure, dans une plaque de verre 16 d'une pluralité de creusures 6 et 21, et par cassure de cette plaque de verre 16 suivant les traits d'axe désignés par la référence 17 sur la fig. 4. Les pièces supérieures 2c sont fabriquées en série de la même façon.

On décrit maintenant en référence aux fig. 5a à 5e un procédé de fabrication par photogravure, d'un ensemble de pièces inférieures 2b.

Sur une plaque de verre 16 ayant typiquement 0,3 à 0,5 mm d'épaisseur, on dépose, sur les deux faces, une couche métallique électro-conductrice de chrome et d'or 19. Sur chacune de ces couches 19 on dépose une couche de résine photosensible 20 (fig. 5a). Après exposition et développement des couches de résine photosensibles 20, ces dernières sont enlevées aux endroits devant être attaqués (fig. 5b).

On commence par enlever, par une attaque chimique convenable, les couches 19 aux endroits non protégés par la couche de résine 20. Les creusures de forme compacte et les parois d'évidements 15 sont alors obtenues par attaque du verre restant à nu de la plaque 16 au moyen d'acide fluorhydrique. Les parois d'évidement 15 sont obtenues par la réalisation dans la plaque 16 de creusures 21 en forme de réseau entourant de tous côtés les creusures 6. Entre les creusures 6 et 21 subsiste une surface annulaire en saillie constituant les surfaces 7 et 10. Au cours de cette même opération d'attaque, on réalise dans la plaque 16, au droit des creusures 21 des perçages oblongs 22 dont le rôle sera expliqué plus loin (fig. 5c).

Les parties de couche de résine photosensibles 20 subsistant après révélation sont alors enlevées. La couche métallique électro-conductrice 19 déposées sur la face par où débouchent les creusures 6 et 21 est alors décapée sélectivement afin de réaliser les pistes conductrices 8 (fig. 5d). Un cristal de quartz 1 est alors monté dans chaque alvéole au droit de la creusure 6 de la plaque 16 gravée, cette alvéole étant destinée à constituer une pièce inférieure 2b de boîtier (fig. 5e).

Les pièces supérieures 2c sont fabriquées, de manière analogue, par gravure d'une plaque de verre 23 dans laquelle on réalise des creusures de forme compacte 5 ainsi que des creusures en forme de réseau 24 destinées à former les parois d'évidements 14. Avant la réalisation des creusures 5 et 24, la plaque de verre 23 est revêtue de couches électro-conductrice 19. Les creusures 5 et 24 sont ménagées à partir d'une face de la plaque 23. Les creusures 24 entourent, à une certaine distance, les creusures 5, de sorte que subsistent des surfaces annulaires en saillie 9 après gravure desdites creusures 5 et 24. On enlève alors, par un décapage sélectif, la couche métallique 19 subsistant sur la face de la plaque 23 par où débouchent les creusures 5 et 24.

On dépose sur les surfaces 9 une couche 11 de Apiezon 140 à une température, typiquement comprise entre 130° et 150°C, à laquelle cette matière présente une viscosité convenable permettant son application en couche mince.

On introduit alors la plaque 23 dans une enceinte 25 dans laquelle se trouve déjà la plaque 16 gravée et munie des quartz 1. La plaque 23 repose sur le fond de l'enceinte 25 par sa face revêtue de la couche 19.

On réalise un vide d'au moins $10^{-4}$ mbar dans l'enceinte 25 (fig. 6a), tout en chauffant les plaques 16 et 23 à une température typiquement comprise entre 130° et 150°C, et on applique la plaque 16 sur la plaque 23 de telle sorte que les faces 10 de la plaque 16 recouvrent exactement les faces 9 munies des couches 11 de la plaque 23.

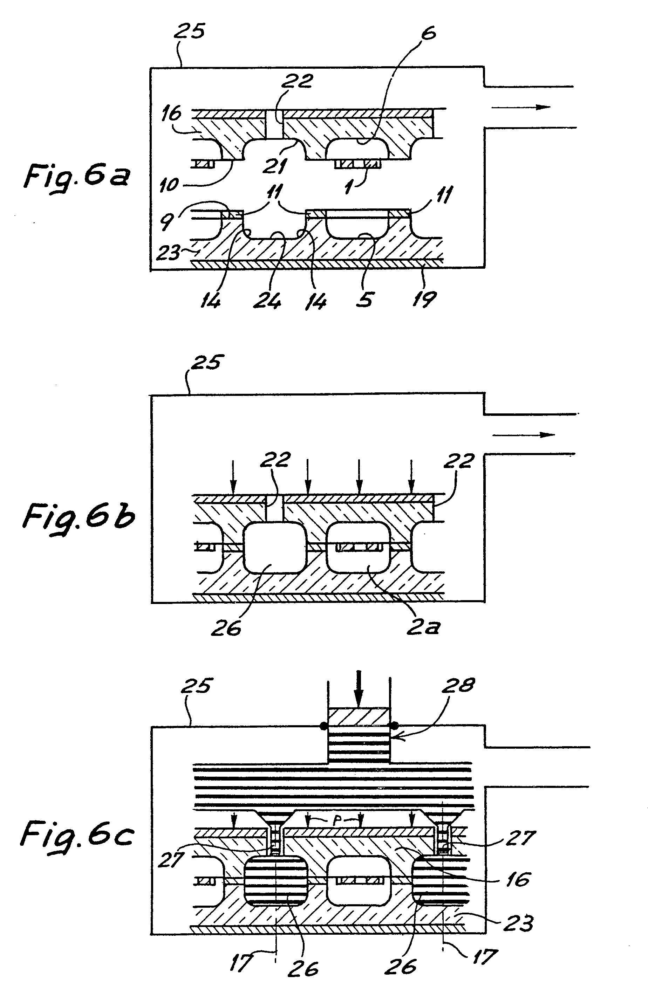

Les creusures 21 et 24 constituent, dans l'ensemble formé par les plaques 16 et 23 appliquées l'une sur l'autre de la façon décrite ci-dessus, un réseau, à mailles rectangulaires, de canaux 26 reliées à l'extérieur par les perçages 22 (fig. 6b).

Lorsqu'on remet l'enceinte 25 à la pression atmosphérique, les plaques 16 et 23 demeurent appliquées l'une sur l'autre avec une certaine pression, car les cavités 2a sont sous vide.

Comme on peut le voir sur la fig. 6c, les canaux 26 sont alors remplis de résine époxy au moyen d'un appareil comportant une pluralité de buses 27 reliées à une source d'époxy sous pression à l'état non polymérisé 28. Les buses 27 sont spatialement disposées de manière à correspondre exactement aux ouvertures 22 de la plaque 16.

Durant l'injection d'époxy dans les canaux 26, il peut être utile d'appliquer sur la plaque 16 une pression uniforme (flèches P de la fig. 6c) afin d'éviter que la plaque 16 ne s'écarte de la plaque 23.

On retire le dispositif d'injection d'époxy 27, 28 et on laisse durcir l'époxy dans les canaux 26 par polymérisation à 100°C avant de sectionner suivant les plans 17 de la fig. 6c, l'ensemble solidaire formé des plaques 16 et 23.

Afin d'éviter que l'époxy ne recouvre les métallisations 8 à leur extrémité opposée au quartz 1, on laisse subsister dans les creusures 24 de la plaque 23 des parties non attaquées 101 telles que représentées en traits mixtes sur la fig. 1. Après le sectionnement suivant les plans 17 on procède encore à l'enlèvement par meulage d'une extrémité 102 de la pièce supérieure 2c de chaque boîtier 2; ladite extrémité 102 qui comprend une partie non attaquée 101, a été représentée en traits mixtes sur la fig. 1.

**Revendications**

1. Oscillateur piézo-électrique, du type comportant:

– un boîtier étanche (2) ayant une cavité (2a), ce boîtier (2) comprenant au moins une première (2b) et une seconde pièce (2c), chacune desdites pièces (2b, 2c) comportant une région centrale (3) délimitant la cavité (2a) du boîtier et une région périphérique (4) ayant une première surface (9), de forme annulaire, pour prendre appui sur la première surface (10) de l'autre pièce (2c, 2b), et une seconde surface (14 resp. 15),
– un élément piézo-électrique (1) monté dans ladite cavité (2a) du boîtier (2), et
– des moyens de scellement (11, 12) pour fermer de façon étanche le boîtier (2),

caractérisé en ce que les moyens de scellement comprennent a) un joint d'étanchéité (11) interposé de façon jointive entre les premières surfaces (9, 10) desdites pièces (2c, 2b) du boîtier (2) et b) un joint de fixation (12) comprenant un matériau durcissable à l'état durci reliant l'une à l'autre lesdites pièces (2b, 2c) du boîtier (2) par leur seconde surface (14, 15).

2. Oscillateur selon la revendication 1, caractérisé en ce que ladite seconde surface (14, 15) d'une pièce (2c, 2b) du boîtier (2) est située à la périphérie de la première surface (9 resp. 10).

3. Oscillateur selon la revendication 2, caractérisé en ce que lesdites secondes surfaces (14, 15) forment les parois d'une rainure périphérique (13) du boîtier (2).

4. Oscillateur selon l'une des revendications 1 à 3, caractérisé en ce que ledit joint d'étanchéité (11) est une couche de cire dont l'épaisseur est de préférence comprise entre 5 et 50 μm.

5. Oscillateur selon la revendication 4, caractérisé en ce que ladite cire comprend une cire minérale.

6. Oscillateur selon l'une des revendications 1 à 5, caractérisé en ce que le matériau durcissable durci est une résine époxy.

7. Oscillateur selon l'une des revendications 1 à 6, caractérisé en ce qu'au moins l'une des pièces (2b, 2c) du boîtier (2) est en verre.

8. Procédé de fabrication d'un oscillateur comprenant un élément piézo-électrique (1) monté dans un boîtier (2) réalisé en au moins deux pièces (2b, 2c) ayant chacune une surface annulaire d'appui (10 resp. 9) par laquelle ladite pièce prend appui sur l'autre pièce, caractérisé en ce qu'on dépose sur au moins l'une des surfaces d'appui une couche de matière d'étanchéité (11), puis on place lesdites pièces dans une enceinte sous vide (25) où on les applique l'une sur l'autre par leur surface d'appui (10, 9), puis on applique un joint de fixation (12) en matière durcissable suivant des secondes surfaces situées chacune à la périphérie de ladite surface annulaire d'appui de chaque pièce et on fait durcir ladite matière.

9. Procédé selon la revendication 8, caractérisé en ce que ladite matière durcissable comprend une résine époxy.

10. Procédé selon la revendication 8, caractérisé en ce que ladite matière d'étanchéité comprend une cire minérale.

**Patentansprüche**

1. Piezoelektrischer Oszillator mit

– einem dichten Gehäuse (2), das einen Hohlraum (2a) aufweist, wobei das Gehäuse (2) wenigstens ein erstes (2b) und ein zweites Teil (2c) umfasst, wobei jedes dieser Teile (2b, 2c) einen mittleren Bereich (3), der den Hohlraum (2a) des Gehäuses begrenzt, und einen Randbereich (4) umfasst, der eine erste Fläche (9), die Ringform besitzt, um sich an der ersten Fläche (10) des anderen Teils (2c, 2b) abzustützen, und eine zweite Fläche (14 bzw. 15) aufweist,
– einem piezoelektrischen Element (1), das in dem Hohlraum (2a) des Gehäuses (2) montiert ist, und
– Verschlussmittel (11, 12) zum dichten Verschliessen des Gehäuses (2), dadurch gekennzeichnet, dass die Verschlussmittel a) eine Dichtung (11), die zwischen die ersten Flächen (9, 10) der Teile (2c, 2b) dichtend zwischengeschaltet ist, und b) eine Befestigungsverbindung (12) umfassen, die ein zum gehärteten Zustand härtbares Material umfasst, das die beiden Teile (2b, 2c) des Gehäuses (2) über ihre zweiten Flächen (14, 15) miteinander verbindet.

2. Oszillator nach Anspruch 1, dadurch gekennzeichnet, dass die zweite Fläche (14, 15) eines Teils (2c, 2b) des Gehäuses (2) am Umfang der ersten Fläche (9 bzw. 10) angeordnet ist.

3. Oszillator nach Anspruch 2, dadurch gekennzeichnet, dass die zweiten Flächen (14, 15) die Wandungen einer Umfangsnut (13) des Gehäuses (2) bilden.

4. Oszillator nach einem der Ansprüche 1 bis 3, dadurch gekennzeichnet, dass die Dichtung (11) eine Wachsschicht ist, deren Stärke vorzugsweise zwischen 5 und 50 μm liegt.

5. Oszillator nach Anspruch 4, dadurch gekennzeichnet, dass das Wachs ein mineralisches Wachs umfasst.

6. Oszillator nach einem der Ansprüche 1 bis 5, dadurch gekennzeichnet, dass das harte härtbare Material ein Epoxyharz ist.

7. Oszillator nach einem der Ansprüche 1 bis 6, dadurch gekennzeichnet, dass wenigstens eines der Teile (2b, 2c) des Gehäuses (2) aus Glas ist.

8. Verfahren zur Herstellung eines Oszillators mit einem piezoelektrischen Element (1), das in einem Gehäuse (2) montiert ist, das aus wenigstens zwei Teilen (2b, 2c) realisiert ist, die jeweils eine ringförmige Abstützfläche (10 bzw. 9) besitzen, über die sich das eine Teil gegenüber dem anderen Teil abstützt, dadurch gekennzeichnet, dass man auf wenigstens eine Abstützfläche eine Schicht aus Abdichtungsmaterial (11) aufbringt, dann die Teile in einem Vakuumraum (25) anordnet, wo man das eine Teil auf dem anderen über ihre Abstützflächen (10, 9) anordnet, dann eine Befestigungsverbindung (12) aus härtbarem Material auf zweiten Flächen die jeweils am Randbereich einer der genannten ringförmigen Abstützflächen liegen, anbringt und das Material aushärten lässt.

9. Verfahren nach Anspruch 8, dadurch gekennzeichnet, dass das härtbare Material ein Epoxyharz umfasst.

10. Verfahren nach Anspruch 8, dadurch gekennzeichnet, dass das Dichtungsmaterial ein mineralisches Wachs umfasst.

## Claims

1. A piezoelectric oscillator, of the kind comprising:

– a fluidtight casing (2) having a cavity (2a), said casing (2) including at least first and second parts (2b, 2c), each of said parts (2b, 2c) comprising a central region (3) defining the cavity (2a) of the casing and a peripheral region (4) having a first, annular, surface (9) for bearing against the first surface (10) of the other part (2c, 2b), and a second surface (14 resp. 15),
– a piezoelectric element (1) mounted in said cavity (2a) of the casing (2), and
– sealing means (11, 12) for fluidtightly closing the casing (2), characterized in that the sealing means include a) a gasket sealingly interposed between the first surfaces (9, 10) of said casing parts (2c, 2b) and b) a securing joint (12) comprising a hardenable material in a hartened state connecting said casing parts (2b, 2c) to one another by their second surface (14, 15).

2. An oscillator according to claim 1, characterized in that said second surface (14, 15) of a casing part (2c, 2b) is located at the periphery of the first surface (9 resp. 10).

3. An oscillator according to claim 2, characterized in that said second surfaces (14, 15) form the walls of a peripheral groove (13) around the casing (2).

4. An oscillator according to any one of claims 1 to 3, characterized in that said gasket (11) is formed by a layer of wax having a thickness preferably lying between 5 and 50 μm.

5. An oscillator according to claim 4, characterized in that said wax comprises a mineral wax.

6. An oscillator according to any one of claims 1 to 5, characterized in that the hardened hardenable material is an epoxy resin.

7. An oscillator according to any one of claims 1 to 6, characterized in that at least one of the casing parts (2b, 2c) is made of glass.

8. A method of producing an oscillator comprising a piezoelectric element (1) mounted in a casing (2) made from at least two parts (2b, 2c) each having an annular bearing surface (10 resp. 9) whereby said part bears on the other part, characterized by the steps of depositing a layer of sealing material (11) on at least one of the bearing surfaces, then placing said parts in an evacuated chamber (25) in which they are applied against each other by their bearing surfaces (10, 9), then applying a securing joint (12) of hardenable material along second surfaces each located at the periphery of said annular bearing surface of each part, and hardening said material.

9. A method according to claim 8, characterized in that said hardenable material comprises an epoxy resin.

10. A method according to claim 8, characterized in that said sealing material comprises a mineral wax.

Fig.1

Fig.2

Fig.3

Fig.4

Fig.5

0 062 604

Fig. 6 a

Fig. 6 b

Fig. 6 c

11